# EUROPEAN PATENT APPLICATION

(11) **EP 4 617 825 A1**
(43) Date of publication of application: **17.09.2025**
(21) Application number: 24889971.8
(22) Date of filing: 15.04.2024
(51) Int. Cl.: G06F 1/20

(54) **COLD PLATE HEAT DISSIPATION SYSTEM HAVING AIR-LIQUID COMPOSITE ARCHITECTURE, MOTHERBOARD, AND SERVER**

(30) Priority: 15.11.2023 CN 202311517910
(71) Applicant: Suzhou Metabrain Intelligent Technology Co., Ltd., Suzhou, Jiangsu 215000 (CN)
(72) Inventor: ZONG, Bin, Suzhou, Jiangsu 215000 (CN); LV, Zhibo, Suzhou, Jiangsu 215000 (CN)
(74) Representative: Studio Torta S.p.A.
(86) International application number: PCT/CN2024/087771
(87) International publication number: WO 2025/102598

(57) **Abstract**

Disclosed in the present invention are a cold plate cooling system of an air-liquid composite architecture, a motherboard, and a server, which relate to the technical field of servers and aim at solving problems of a small total heat exchange area and cooling waste. The system includes a heat exchange cavity (1), a water inflow pipe (2), and a water outflow pipe (3). A bottom surface of the heat exchange cavity (1) is configured for abutting against a heating element. The system further includes a cooling assembly (4) and a heat conduction assembly (5). The cooling assembly (4) includes at least one cooling fin (41), a bottom of the cooling fin (41) is connected to the bottom surface of the heat exchange cavity (5), and the water inflow pipe (2) and the water outflow pipe (3) are located at two ends of the cooling fin (41) in a length direction respectively. A bottom of the heat conduction assembly (5) is connected to the bottom surface of the heat exchange cavity (1), and a top of the heat conduction assembly (5) is connected to a top of the cooling fin (41), so as to transfer part of heat absorbed by the heat exchange cavity (1) to the top of the cooling fin (41). The present invention is able to increase a total heat exchange area between cooling liquid and the heating element, reduce cooling waste of cooling liquid at a top as much as possible, optimize cooling temperature uniformity, and improve cooling efficiency of cold plate liquid-cooling technology.

## Description

### Cross-Reference to Related Application

The present invention claims the priority of Chinese Patent Application No. 202311517910.2, filed with the China National Intellectual Property Administration (CNIPA) on November 15, 2023 and entitled "Cold Plate Cooling System of Air-liquid Composite Architecture, Motherboard, and Server", which is herein incorporated by reference in its entirety.

### Technical Field

The present invention relates to the technical field of servers, and in particularly to a cold plate cooling system of an air-liquid composite architecture, a motherboard, and a server.

### Background

A server, as an important part of an electronic device, is primarily configured to provide computing services. Depending on types of services provided by servers, the servers are mainly categorized as file servers, database servers, application servers, web servers, and so on. Main components of a server include a case, a motherboard, a central processing unit (CPU), a graphic processing unit (GPU), a hard disk, a memory, a power supply, a heat sink, etc., which are similar to a general-purpose computer architecture.

In recent years, heat generated by servers keeps increasing with increasing performance. Air cooling in traditional servers cannot satisfy the cooling performance of the server, and leads to high energy consumption and high noise level. Thus air cooling has been gradually eliminated and replaced by liquid-cooling technology. In the industry, the liquid-cooling technology is mainly categorized into direct liquid-cooling technology and indirect liquid-cooling technology.

The direct liquid-cooling technology is immersion liquid-cooling technology in most cases. According to the technology, the server is immersed in the insulated cooling liquid, and heat generated by operation of the server is taken away by a circulating cooling liquid. However, the immersion liquid-cooling technology has high environmental requirements and a low utilization of space in a server room, and requires huge costs of configuration, operation, maintenance and reconstruction are huge. Further, the risk of corroding the servers by the cooling liquid is still unclear. Due to the above disadvantages, the direct liquid-cooling technology can hardly become the prevalent liquid-cooling technology and can be applied only to ultra-high-density data centers.

Currently, the indirect liquid-cooling technology has been widely used. The indirect liquid-cooling technology is cold plate liquid-cooling technology in most cases. According to the technology, working fluid (such as cooling liquid and low-temperature gas) is used as a medium for heat transfer. The working fluid flows in a cold plate. Then the heat from a heating element (such as CPU) in the server is absorbed through the cold plate. Finally the heat is transferred to the working fluid, from which the heat is transferred to a distant location for further cooling. In this process, the working fluid is separated from the heating element and does not make direct contact with the heating element. By using the cold plate as a heat transfer component between the working fluid and the heating element, as well as heat absorbing materials such as heat-conducting silicone grease coating the cold plate, the heat from the heating element can be quickly transferred to the working fluid.

In the related art, copper plates and other metal plates are commonly used as liquid cooling plates in the cold plate liquid-cooling technology. The interior of a metal plate is hollowed out to form a heat exchange cavity capable of holding a certain amount of cooling liquid. Then a water inflow pipe and a water outflow pipe are inserted at the two ends of the thin metal plate respectively. Finally, a cooling dispensing unit (CDU) is connected to implement circulation flow of the cooling liquid in the heat exchange cavity of the thin metal plate. However, on the one hand, since the heating elements such as the central processing unit and the graphic processing unit generally have a small size and a small exposed area but high heating power, a contact area between the liquid cooling plate and the heating element is extremely limited, and a total heat exchange area between the cooling liquid and the heating element is small. On the other hand, owing to laminar flow characteristics and the self-weight influence of the cooling liquid, when the cooling liquid enters the heat exchange cavity of the metal plate from the water inflow pipe, the cooling liquid at the bottom always can fully absorb heat from the heating element, while the cooling liquid at the top cannot easily fully absorb the heat from the heating element. Due to a pumping drive effect in the cooling dispensing unit, the cooling liquid flows quickly, so the cooling liquid at the top tends to flow directly out of the heat exchange cavity before fully absorbing the heat. In consequence, undesirable cooling temperature uniformity and cooling waste of part of the cooling liquid are caused.

### Summary

Some embodiments of the present invention provide a cold plate cooling system of an air-liquid composite architecture. The cold plate cooling system of the air-liquid composite architecture includes a heat exchange cavity, and a water inflow pipe and a water outflow pipe that are in communication with the heat exchange cavity. An interior of the heat exchange cavity is configured for accommodating cooling liquid, and a bottom surface of the heat exchange cavity is configured for abutting against a heating element. The cold plate cooling system of the air-liquid composite architecture further includes a cooling assembly and a heat conduction assembly that are mounted in the heat exchange cavity;
the cooling assembly includes a cooling fin, and there is at least one cooling fin, a bottom of the cooling fin is connected to the bottom surface of the heat exchange cavity and extends in a height direction of the heat exchange cavity, and a water outlet of the water inflow pipe and a water inlet of the water outflow pipe are located at two ends of the cooling fin in a length direction respectively;
a bottom of the heat conduction assembly is connected to the bottom surface of the heat exchange cavity, and a top of the heat conduction assembly is connected to a top of the cooling fin, part of heat absorbed by the heat exchange cavity is transferred to the top of the cooling fin.

In some embodiments, the water outlet of the water inflow pipe and the water inlet of the water outflow pipe are both in communication with a top of the heat exchange cavity, and are located at two ends of the heat exchange cavity in a length direction respectively.

In some embodiments, the water outlet of the water inflow pipe is in communication with a top of the heat exchange cavity, the water inlet of the water outflow pipe is in communication with a bottom of a side wall of the heat exchange cavity, and the water outlet of the water inflow pipe and the water inlet of the water outflow pipe are located at two ends of the heat exchange cavity in a length direction respectively.

In some embodiments, a top wall of the heat exchange cavity is a vapor chamber, the top of the cooling fin extends to be connected to the vapor chamber, and the vapor chamber is configured for naturally exchanging part of heat of the cooling fin with outside air.

In some embodiments, the cold plate cooling system of the air-liquid composite architecture is applied to a server, the server includes a cooling fan, and a height of the heat exchange cavity equals a height of an air duct formed by the cooling fan in the server.

In some embodiments, the cooling assembly includes two cooling fins at a head end and a tail end, side walls on two sides of the heat exchange cavity in a width direction are heat conduction medium walls, the two cooling fins at the head end and the tail end are attached to inner walls on the two sides of the heat exchange cavity in the width direction respectively, and an air-cooling fin is provided on outer walls on the two sides of the heat exchange cavity in the width direction.

In some embodiments, the bottom of the cooling fin is welded to the bottom surface of the heat exchange cavity, and a thickness of the cooling fin is 0.2 mm to 0.3 mm.

In some embodiments, two side surfaces of the cooling fin are provided with a protrusion and/or a recess to increase a surface area.

In some embodiments, the cooling assembly includes a plurality of cooling fins, the heat conduction assembly includes a bottom heat pipe covering the bottom surface of the heat exchange cavity, a column heat pipe erected on a surface of the bottom heat pipe, and a top heat pipe arranged at a top end of the column heat pipe; the column heat pipe extends vertically to a predetermined height position of the plurality of cooling fins; and the top heat pipe sequentially penetrates the plurality of cooling fins.

In some embodiments, the top heat pipe perpendicularly penetrates the plurality of cooling fins, and the top heat pipe penetrates tops and/or middles of the plurality of cooling fins.

In some embodiments, the cooling assembly includes the plurality of cooling fins, and the bottom heat pipe extends in an arrangement direction of the plurality of cooling fins and is uniformly distributed in a length direction of the plurality of cooling fins.

In some embodiments, the cooling assembly includes the plurality of cooling fins, each of the plurality of cooling fins is provided with a through hole allowing the top heat pipe to penetrate, an extension sleeve is connected between hole walls of through holes of two adjacent cooling fins of the plurality of cooling fins, and the extension sleeve is configured for sleeving on the top heat pipe.

In some embodiments, a gap between an outer pipe wall of the top heat pipe and an inner pipe wall of the extension sleeve is filled with heat conduction flux for welding formation.

In some embodiments, the cooling assembly includes a plurality of cooling fins, the cold plate cooling system of the air-liquid composite architecture further includes a water distribution pipe in communication with the water outlet of the water inflow pipe, the water distribution pipe extends in an arrangement direction of the plurality of cooling fins, and a plurality of uniformly distributed water outlets are provided on the water distribution pipe.

In some embodiments, the cooling assembly includes the plurality of cooling fins, the cold plate cooling system of the air-liquid composite architecture further includes a water collection pipe in communication with the water inlet of the water outflow pipe, the water collection pipe extends in an arrangement direction of the plurality of cooling fins, and a plurality of uniformly distributed water inlets are provided on the water collection pipe.

In some embodiments, a plurality of heat exchange cavities are provided, each of the plurality of heat exchange cavities is configured for abutting against different heating elements respectively, and each of the plurality of heat exchange cavities is connected in series through the water inflow pipe and the water outflow pipe.

In some embodiments, the cold plate cooling system of the air-liquid composite architecture further includes a heat conduction plate arranged on the bottom surface of the heat exchange cavity, where a bottom surface of the heat conduction plate is a smooth plane and is configured for pressing a top surface of the heating element and absorbing heat of the heating element.

In some embodiments, the heat conduction plate is detachably connected to the heat exchange cavity, and the heat conducting plate matching the heating element in size is detachable and replaceable on the heat exchange cavity.

In some embodiments, a snap-fit groove is provided at a fixed position on a top surface of the heat conduction plate;
a guide chute extending vertically is provided on the bottom surface of the heat exchange cavity, a guide slider is arranged in the guide chute, a bottom of the guide slider is provided with a snap-fit member, a side wall of the guide slider is provided with an inserting-pulling operation block, and the snap-fit member is configured for forming a snap-fit connection with the snap-fit groove; and the inserting-pulling operation block is configured for applying a vertical force to the guide slider to insert the snap-fit member into the snap-fit groove or pull the snap-fit member out of the snap-fit groove.

In some embodiments, a top end of the guide slider is magnetically connected to a top end of the guide chute; and/or the snap-fit member is magnetically connected to the snap-fit groove.

Some other embodiments of the present invention further provide a motherboard, including a board body, a heating element arranged on a surface of the board body, and a cooling system for cooling the heating element, the cooling system is the cold plate cooling system of the air-liquid composite architecture described above.

Still some other embodiments of the present invention further provide a server, including a case, a motherboard mounted in the case, and cooling fans arranged at two ends of the case, the motherboard is the motherboard described above.

The cold plate cooling system of the air-liquid composite architecture provided in the present invention mainly includes a heat exchange cavity, a water inflow pipe, a water outflow pipe, a cooling assembly, and a heat conduction assembly. The heat exchange cavity is a main structure of the cooling system, and is internally provided with a sealed cavity in a specific shape, is able to accommodate a certain amount of cooling liquid, is mainly configured for allowing other parts of the cooling system to be mounted and accommodated, and further provides an environment for heat exchange between the cooling liquid and a heating element. A bottom surface of the heat exchange cavity is configured for abutting against the heating element (mainly being a server assembly, such as a central processing unit and a graphic processing unit, with large heat generation), and is generally pressed against an exposed top surface of the heating element, so as to absorb heat generated by the heating element during operation. The water inflow pipe and the water outflow pipe are both in communication with the heat exchange cavity. The water inflow pipe is mainly configured for introducing new cooling liquid into the heat exchange cavity. The water outflow pipe is mainly configured for discharging cooling liquid which has absorbed heat out of the heat exchange cavity. Thus continuous circulation flow of the cooling liquid in the heat exchange cavity is achieved. The cooling assembly, one of core components, is integrally mounted in the heat exchange cavity, and mainly includes a plurality of cooling fins. A bottom of each cooling fin is connected to the bottom surface of the heat exchange cavity. Each cooling fin extends in a height direction (or vertically) in the heat exchange cavity, and is mainly configured for gradually dispersing the heat absorbed by the heat exchange cavity from the heating element to side surfaces of the entire cooling fin from bottom to top. Thus when the cooling liquid circulates in the heat exchange cavity, the cooling liquid is able to make contact with the side surfaces on two sides of each cooling fin, that is, the cooling liquid at a bottom makes contact with bottoms of the side surfaces of the cooling fin, and the cooling liquid at a top makes contact with tops of the side surfaces of the cooling fin. Accordingly, dispersed heat is absorbed from the side surfaces of the cooling fin, and liquid cooling is achieved. Moreover, a water outlet of the water inflow pipe and a water inlet of the water outflow pipe are located at two ends of each cooling fin in a length direction respectively. Thus when the cooling liquid flows in the heat exchange cavity, the cooling liquid is able to flow in from one end of a gap between two adjacent cooling fins, completely flow through the side surfaces of each cooling fin, and then flow out from the other end of the gap. The heat conduction assembly is another core component and is integrally mounted in the heat exchange cavity. A bottom of the heat conduction assembly is connected to the bottom surface of the heat exchanging cavity. A top of the heat conduction assembly is connected to a top of each cooling fin. The heat conduction assembly is mainly configured for absorbing part of heat from the heating element through the bottom surface of the heat exchanging cavity and directly transfers the heat to the top of each cooling fin in an extending direction of the heat conduction assembly. Thus the top of each cooling fin receives heat, and the heat is gradually dispersed to the side surfaces of the entire cooling fin from bottom to top. Accordingly, there is no need to wait for the heat to be gradually transferred upwards from the bottom of each cooling fin.

### Brief Description of the Drawings

In order to more clearly illustrate technical solutions in the embodiments of the present invention or in the related art, a brief introduction to the accompanying drawings required for the description of the embodiments or the related art will be provided below. Apparently, the accompanying drawings in the following description are merely the embodiments of the present invention, and those of ordinary skill in the art would also be able to derive other drawings from these provided drawings without making creative efforts.
Fig. 1 is an overall structural schematic diagram of a cold plate cooling system of an air-liquid composite architecture according to an embodiment of the present invention;
Fig. 2 is a structural schematic diagram of a heat exchange cavity according to an embodiment of the present invention;
Fig. 3 is an internal structural schematic diagram of a heat exchange cavity according to an embodiment of the present invention;
Fig. 4 is a side view of a heat exchange cavity of Fig. 3 according to an embodiment of the present invention;
Fig. 5 is a schematic diagram of a connection structure between a cooling fin and a top heat pipe according to an embodiment of the present invention;
Fig. 6 is a structural schematic diagram of a heat conduction assembly according to an embodiment of the present invention;
Fig. 7 is a structural schematic diagram of a heat conduction plate according to an embodiment of the present invention;
Fig. 8 is a partial structural schematic diagram of a heat exchange cavity according to an embodiment of the present invention;
Fig. 9 is a structural schematic diagram of a motherboard according to an embodiment of the present invention; and
Fig. 10 is a structural schematic diagram of a server according to an embodiment of the present invention.

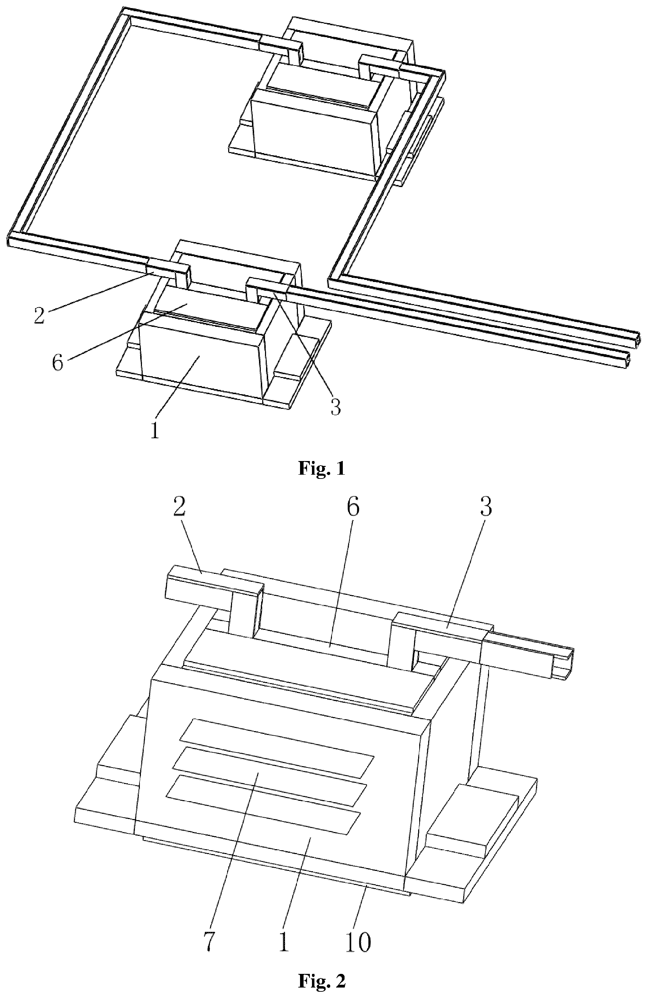

In Figs. 1-8:
heat exchange cavity-1, water inflow pipe-2, water outflow pipe-3, cooling assembly-4, heat conduction assembly-5, vapor chamber-6, air-cooling fin-7, water distribution pipe-8, water collection pipe-9, and heat conduction plate-10;
guide chute-11, guide slider-12, snap-fit member-13, and inserting-pulling operation block-14;
cooling fin-41, and extension sleeve-42;
bottom heat pipe-51, column heat pipe-52, and top heat pipe-53; and
snap-fit groove-101.

### Detailed Description of the Embodiments

The technical solutions in embodiments of the present invention are clearly and completely described below with reference to the accompanying drawings in the embodiments of the present invention. Apparently, the embodiments described are merely some embodiments rather than all embodiments of the present invention. All other embodiments obtained by a person of ordinary skill in the art based on the embodiments of the present invention without creative efforts shall fall within the protection scope of the present invention.

With reference to Fig. 1, Fig. 1 is an overall structural schematic diagram of a cold plate cooling system of an air-liquid composite architecture according to an embodiment of the present invention.

In an embodiment provided in the present invention, the cold plate cooling system of the air-liquid composite architecture mainly includes a heat exchange cavity 1, a water inflow pipe 2, a water outflow pipe 3, a cooling assembly 4, and a heat conduction assembly 5.

As shown in Fig. 2, Fig. 2 is a structural schematic diagram of a heat exchange cavity 1 according to an embodiment of the present invention.

The heat exchange cavity 1 is a main structure of the cooling system, and is internally provided with a sealed cavity in a specific shape, is able to accommodate a certain amount of cooling liquid, is mainly configured for allowing other parts of the cooling system to be mounted and accommodated, and further provides an environment for heat exchange between the cooling liquid and a heating element. A bottom surface of the heat exchange cavity 1 is configured for abutting against the heating element (mainly being a server assembly, such as a central processing unit and a graphic processing unit, with large heat generation), and is generally pressed against an exposed top surface of the heating element, so as to absorb heat generated by the heating element during operation.

The water inflow pipe 2 and the water outflow pipe 3 are both in communication with the heat exchange cavity 1. The water inflow pipe 2 is mainly configured for introducing new cooling liquid into the heat exchange cavity 1. The water outflow pipe 3 is mainly configured for discharging cooling liquid which has absorbed heat out of the heat exchange cavity 1. Thus continuous circulation flow of the cooling liquid in the heat exchange cavity 1 is achieved.

The cooling assembly 4 is one of core components, is integrally mounted in the heat exchange cavity 1, and mainly includes a cooling fin 41, and there is at least one cooling fin 41. It should be noted that the number of the cooling fins 41 is not limited in the present invention. The number of the cooling fins 41 is determined according to actual cooling requirements. A bottom of the cooling fin 41 is connected to the bottom surface of the heat exchange cavity 1. The cooling fin 41 extends in the heat exchange cavity 1 in a height direction (or vertically) in the heat exchange cavity 1, and is mainly configured for gradually dispersing the heat absorbed by the heat exchange cavity 1 from the heating element to side surfaces of the entire cooling fin 41 from bottom to top. Thus when the cooling liquid circulates in the heat exchange cavity 1, the cooling liquid is able to make contact with the side surfaces on two sides of the cooling fin 41, that is, the cooling liquid at the bottom makes contact with bottoms of the side surfaces of the cooling fin 41, and the cooling liquid at the top makes contact with tops of the side surfaces of the cooling fin 41. Accordingly, dispersed heat is absorbed from the side surfaces of the cooling fin 41, and liquid cooling is achieved. Moreover, a water outlet of the water inflow pipe 2 and a water inlet of the water outflow pipe 3 are located at two ends of the cooling fin 41 in a length direction respectively. Thus when the cooling liquid flows in the heat exchange cavity 1, the cooling liquid is able to flow in from one end of a gap of the cooling fin 41, completely flow through the side surface of the cooling fin 41, and then flow out from the other end of the cooling fin 41. When the cooling assembly 4 includes a plurality of cooling fins 41, it is also guaranteed that the cooling liquid is able to flow in from one end of a gap between the cooling fins 41, completely flow through the side surfaces of each cooling fin 41, and then flow out from the other end of the gap.

The heat conduction assembly 5 is another core component and is integrally mounted in the heat exchange cavity 1. A bottom of the heat conduction assembly 5 is connected to the bottom surface of the heat exchanging cavity 1. A top of the heat conduction assembly 5 is connected to a top of the cooling fin 41. The heat conduction assembly is mainly configured for absorbing part of heat from the heating element through the bottom surface of the heat exchanging cavity 1 and directly transfers the heat to the top of the cooling fin 41 in an extending direction of the heat conduction assembly 5. Thus the top of the cooling fin 41 receives heat, and the heat is gradually dispersed to the side surface of the entire cooling fin 41 from bottom to top. Accordingly, there is no need to wait for the heat to be gradually transferred upwards from the bottom of the cooling fin 41.

In this way, in the cold plate cooling system of the air-liquid composite architecture provided in the embodiment, the heat absorbed by the heat exchange cavity 1 from the heating element is dispersed to the entire side surface through the cooling fin 41 in the cooling assembly 4. Thus when the cooling liquid circulates in the heat exchange cavity 1, the heat of the heating element is able to be absorbed not only directly through the bottom surface of the heat exchange cavity 1, but also indirectly through the side surface of the cooling fin 41. Moreover, an area of the side surface of the cooling fin 41 is significantly greater than a bottom surface area of the heat exchange cavity 1, a large number of cooling fins 41 is able to be arranged, and the side surface of each cooling fin 41 is able to make contact with the cooling liquid, such that a total heat exchange area between the cooling liquid and the heating element is greatly increased.

Moreover, when the cooling liquid circulates in the heat exchange cavity 1, the cooling liquid at the bottom makes contact with the bottom of the cooling fin 41 and the cooling liquid at the top makes contact with the top of the cooling fin 41 due to a laminar flow characteristic, the heat at the bottom of the cooling fin 41 is more concentrated, and heat density dispersed to the top is lower, but part of the heat of the heating element is able to be directly transferred to the top of the cooling fins 41 under the action of the heat conduction assembly 5. Thus the heat received and dispersed by the top of the cooling fin 41 is increased, then the heat density at the bottom and the top of the cooling fin 41 tends to be even, and the cooling liquid at the top is also able to fully absorb heat from the top of the side surface of the cooling fin 41, such that cooling waste is avoided.

In summary, the cold plate cooling system of the air-liquid composite architecture provided in the embodiment integrates characteristics of air-cooling technology and liquid-cooling technology in cold plate liquid-cooling technology to form a composite architecture. The cold plate cooling system is able to increase a total heat exchange area between cooling liquid and the heating element, reduce coolant waste of top-layer cooling liquid as much as possible, optimize cooling temperature uniformity, and improve cooling efficiency of cold plate liquid-cooling technology.

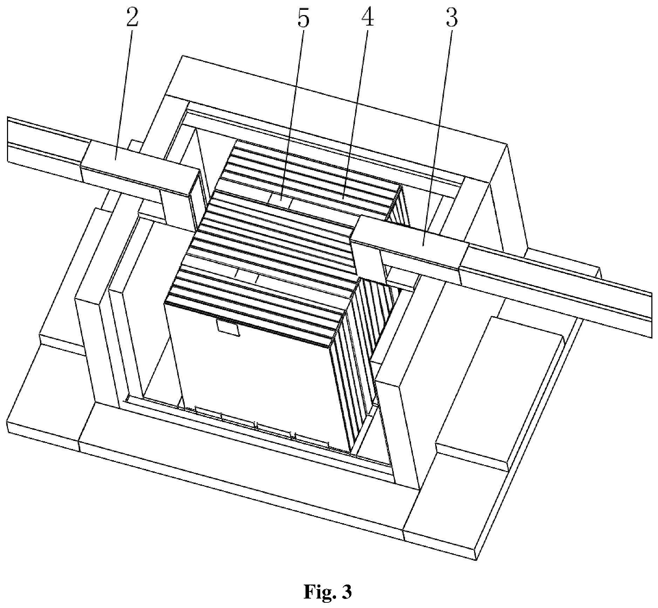

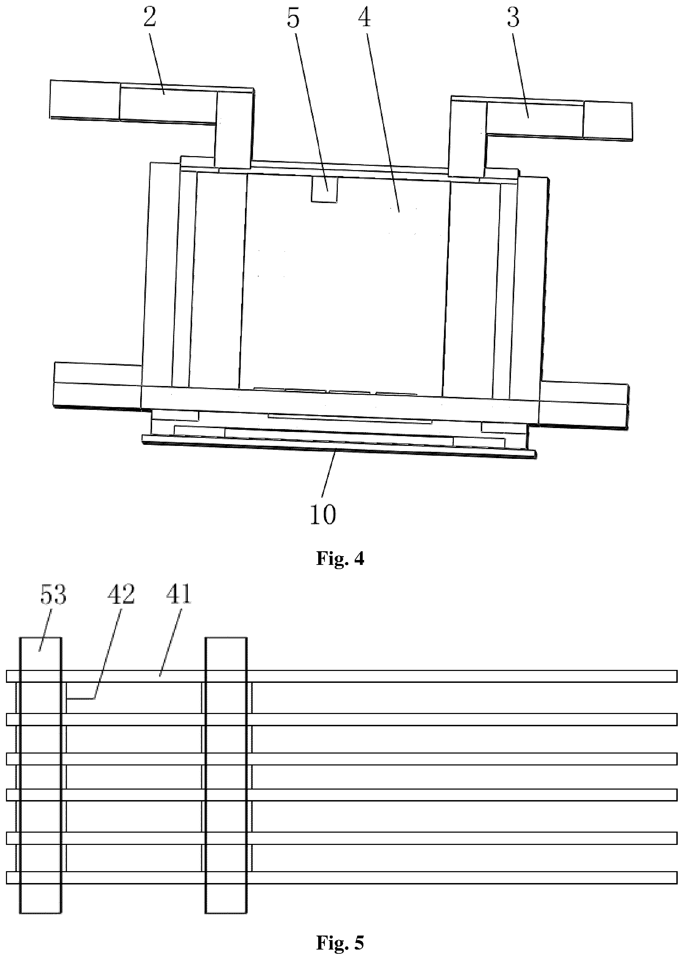

As shown in Fig. 3 and Fig. 4, Fig. 3 is an internal structural schematic diagram of a heat exchange cavity 1 according to an embodiment of the present invention; and Fig. 4 is a side view of a heat exchange cavity of Fig. 3 according to an embodiment of the present invention.

In some embodiments of the cooling assembly 4, the cooling assembly 4 is integrally mounted at a middle of the heat exchange cavity 1 in a length direction. The cooling fin 41 extends in the length direction of the heat exchange cavity 1, such that an internal space of the heat exchange cavity 1 is divided into three regions, that is, a middle region where the cooling assembly 4 is mounted and end regions at two ends in the length direction. The two end regions are a water inlet region and a water discharge region of the cooling liquid.

In some embodiments of the water inflow pipe 2 and the water outflow pipe 3, the water outlet of the water inflow pipe 2 and the water inlet of the water outflow pipe 3 are in communication with the top of the heat exchange cavity 1. The water outlet of the water inflow pipe 2 and the water inlet of the water outflow pipe 3 are located at two ends of the heat exchange cavity 1 in the length direction respectively, that is, are located at the water inlet region and the water discharge region respectively. In this way, after flowing out from the water outlet of the water inflow pipe 2, the cooling liquid falls into the water inlet region, flows out to the water discharge region through the gaps between the cooling fins 41, and is finally discharged through the water outflow pipe 3. Such a distribution structure of the water inflow pipe 2 and the water outflow pipe 3 reuses a conventional cold plate structure, such that a pipe structure on the motherboard does not need to be changed. Moreover, the water inflow pipe 2 and the water outflow pipe 3 are located at a same height plane, and are easy to arrange and disassemble.

In another embodiment of the water inflow pipe 2 and the water outflow pipe 3, the water inflow pipe 2 and the water outflow pipe 3 are not located at the same height plane. Only the water outlet of the water inflow pipe 2 is in communication with the top of the heat exchange cavity 1. The water inlet of the water outflow pipe 3 is in communication with a bottom of a side wall of the heat exchange cavity 1. Thus a high-low distribution structure of water inlet and water outlet is formed. Certainly, the water outlet of the water inflow pipe 2 and the water inlet of the water outflow pipe 3 are still located at the two ends of the heat exchange cavity 1 in the length direction respectively. In this way, since the cooling liquid at the top absorbs less heat than the cooling liquid at the bottom, in a case that the water inlet of the water outflow pipe 3 is in communication with the top of the heat exchange cavity 1, the cooling liquid at the top is easier to flow out directly after absorbing the heat at the top of the cooling fin 41. In the embodiment, after absorbing the heat at the top of the cooling fin 41, the cooling liquid at the top is not able to flow out directly from the top, but needs to flow downwards to the bottom of the heat exchange cavity 1 before flowing out. Accordingly, a fluidity of the cooling liquid at the top is enhanced, the cooling liquid at the top absorbs heat as fully as possible, the cooling liquid in the heat exchange cavity 1 is utilized to the maximum, and cooling waste is further reduced.

Considering that each cooling fin 41 is uniformly arranged in the heat exchange cavity 1 in a width direction of the heat exchange cavity 1, in order to enable the cooling liquid to enter the gap between any two adjacent cooling fins 41 as uniformly and synchronously as possible after entering the water inlet region, a water distribution pipe 8 is additionally provided in the embodiment. In some embodiments, the water distribution pipe 8 is arranged in the water inlet region of the heat exchange cavity 1, is in communication with the water outlet of the water inflow pipe 2, and is distributed in the width direction of the heat exchange cavity 1, that is, in an arrangement direction of each cooling fin 41. Furthermore, a plurality of water outlets are provided on the water distribution pipe 8 in a length direction. Generally, each of the plurality of water outlets is uniformly distributed in a length direction of the water distribution pipe 8. In this way, when entering the water distribution pipe 8 through the water inflow pipe 2, the cooling liquid simultaneously falls into various positions in the water inlet region of the heat exchange cavity 1 from each of the plurality of water outlets, such that it is guaranteed that the cooling liquid is able to uniformly and synchronously enter the gaps between the cooling fins 41.

Similarly, in order to make the cooling liquid discharged into the water outflow pipe 3 uniformly and synchronously as much as possible after absorbing heat, a water collection pipe 9 is additionally arranged in the embodiment. In some embodiments, the water collection pipe 9 is arranged in the water discharge region of the heat exchange cavity 1, is in communication with the water inlet of the water outflow pipe 3, and is distributed in the width direction of the heat exchange cavity 1, that is, in an arrangement direction of each cooling fin 41. Furthermore, a plurality of water inlets are provided on the water collection pipe 9 in a length direction. Generally, each of the plurality of water inlets is uniformly distributed in a length direction of the water collection pipe 9. In this way, after absorbing heat and flowing into the water discharge region, the cooling liquid enters the water outflow pipe 3 from each of the plurality of water inlets at various positions in the water discharge region simultaneously and is discharged, such that it is guaranteed that the cooling liquid is able to uniformly and synchronously enter the gap between each cooling fin 41, and short-term accumulation of the heat in the water discharge region is avoided.

In some embodiments of the heat exchange cavity 1, considering that the heat conduction assembly 5 directly transfers part of the heat of the heating element to the top of the cooling fins 41, so as to facilitate absorption by the cooling liquid at the top, in order to enhance cooling efficiency of the top of the cooling fins 41, a top wall of the heat exchange cavity 1 in the embodiment is a vapor chamber 6, and the top of each cooling fin 41 extends to be connected to the vapor chamber 6. In this way, the heat at the top of the cooling fin 41 is able to not only be absorbed by the cooling liquid at the top, but also be transferred to the vapor chamber 6. The vapor chamber 6 is able to uniformly disperse the heat on a plate surface, such that the vapor chamber 6 is able to perform natural heat exchange with outside air or convective heat exchange with cold air in a server case. Accordingly, heat exchange efficiency is further improved to a certain extent.

Further, considering that a height of a conventional cold plate is lower and has a significant height difference from a height of an air-cooling radiator (a fan, etc.) mounted in a server, an ineffective cooling waste exists in an air duct above the cold plate. In view of this, in the embodiment, a height of the heat exchange cavity 1 is increased, and is generally 3 to 4 times the height of the conventional cold plate until the height is consistent with the height of the air duct formed by a cooling fan in the server. In this way, the height of the heat exchange cavity 1 matches the height of a specific air duct in the server case. When passing through the heat exchange cavity 1, cold air corresponding to the air duct is blocked and is not able to continue to pass, such that the cold air flows to two sides of the heat exchange cavity 1 for diversion flowing, and finally adds into other air ducts to supplement a cooling capacity, and the cold air on the air duct is prevented from being wasted. Moreover, in traditional cold plate liquid-cooling technology, the cold plate needs to be filled with foam to block an air duct above the cold plate, or a modeling structure of an air guide cover for air cooling needs to be adjusted to divert the air duct above the cold plate through the air guide cover. However, in the embodiment, the height of the heat exchange cavity 1 is increased to be consistent with the height of the air duct formed by the cooling fan, such that the height of the cooling fin 41 is able to be increased, and the area of the cooling fin 41 and the total heat exchange area are able to be increased. The original space above the cold plate is reasonably used, such that no foam is needed for filling. Material cost is saved. Moreover, the modeling structure of the air guide cover does not need to be adjusted, and a related air guide cover is able to be directly reused in the server. Moreover, under a condition that parameters such as pressure and a flow rate of the cooling liquid remain unchanged, since a volume increases due to the increase in the height of the heat exchange cavity 1, the pressure in the heat exchange cavity 1 is also reduced, and thus the risk of liquid leakage is reduced.

Similarly, in the embodiment, the cooling efficiency is able to be enhanced not only by the top wall of the heat exchange cavity 1, but also by the side walls on the two sides of the heat exchange cavity 1. In some embodiments, the side walls on the two sides of the heat exchange cavity 1 in the width direction are heat conduction medium walls, such as metal walls made of copper. The two cooling fins 41 at the head end and the tail end (that is, the cooling fins 41 located on the two sides of the heat exchange cavity 1 in the width direction) in the cooling assembly 4 are attached to inner walls on the two sides of the heat exchange cavity 1 in the width direction respectively. Moreover, an air-cooling fin 7 is further provided on outer wall surfaces of the two side walls. In this way, the two cooling fins 41 at the head end and the tail end in the cooling assembly 4 are able to simultaneously transfer heat to the side walls on the two sides of the heat exchange cavity 1, and then transfer the heat to the air-cooling fin 7. The air cooling fin 7 makes contact with an external cold air for air cooling, such that the cooling efficiency of the heating element is further improved in combination with air cooling. Certainly, the air-cooling fin 7 is also able to be arranged on a front end surface or a top end surface of the heat exchange cavity 1, but when the height of the heat exchange cavity 1 reaches a limit position, the air-cooling fin 7 is not arranged on the top surface.

In some embodiments of the cooling fin 41, considering that the conventional cooling fin generally need to be manufactured and assembled through a tooth cutting or saw-tooth process, due to process limitations, a thickness of the conventional cooling fin needs to be kept within a range of 1 mm to 2 mm in order to produce a desirable heat conduction effect, but a width size of the heat exchange cavity 1 is small, and the thickness of 1 mm to 2 mm is too great for the heat exchange cavity 1, such that a plurality of cooling fins are not able to be arranged in the heat exchange cavity 1. The total heat exchange area is limited. In view of this, in the embodiment, the bottom of each cooling fin 41 is fixed to the bottom surface of the heat exchange cavity 1 by welding. A thickness of each cooling fin 41 is 0.2 mm to 0.3 mm, such as 0.2 mm, 0.25 mm, and 0.3 mm. In this way, through welding connection between each cooling fin 41 and the bottom surface of the heat exchange cavity 1, a manufacturing thickness of the cooling fin 41 is not limited by the tooth cutting or saw tooth process, and is able to become thinner, such that a distance between two adjacent cooling fins 41 is able to be reduced. Thus more cooling fins 41 are able to be arranged in the heat exchange cavity 1, and the total heat exchange area is increased. Moreover, due to the action of the heat conduction assembly 5, part of the heat of the heating element is directly transferred to the top of the cooling fin 41 without a process of gradually dispersing from the bottom to the top of the cooling fin 41, such that the heat conduction efficiency is substantially not influenced.

In another embodiment of the cooling fins 41, in order to further improve the total heat exchange area, in the embodiment, a protrusion or a recess is provided on two side surfaces of each cooling fin 41, or the protrusion and the recess are both provided.

Generally, the protrusion and the recess are arc-shaped, such that a minute convex portion and a concave pit are formed on the side surface of the cooling fin 41. In this way, the protrusion and the recess are able to effectively increase a surface area of the side surface of the cooling fin 41, thereby increasing a contact area between the cooling liquid and the cooling fin 41 when the cooling liquid flows through the side surface of the cooling fin 41, and further improving the cooling efficiency to a certain extent. Moreover, the protrusion and the recess are arc-shaped, so as to generate a flow guiding effect on the cooling liquid, and avoid flow rate reduction and heat accumulation caused by obstruction to the cooling liquid.

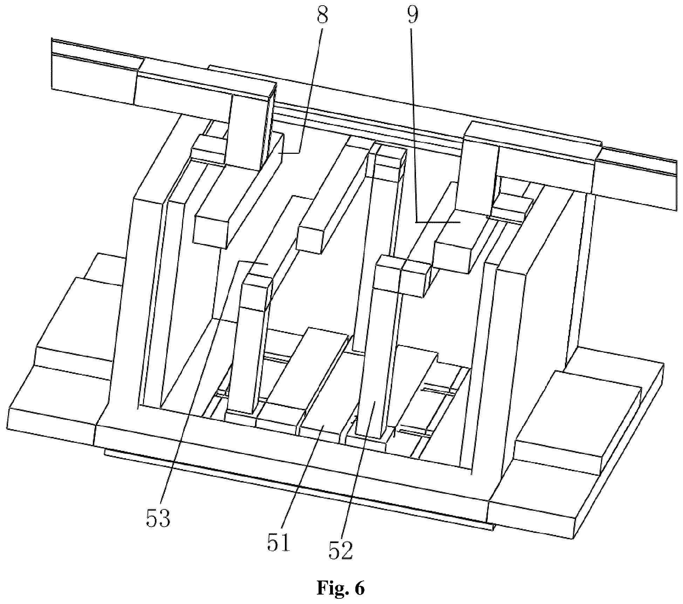

As shown in Fig. 6, Fig. 6 is a structural schematic diagram of a heat conduction assembly 5 according to an embodiment of the present invention.

In some embodiments of the heat conduction assembly 5, the heat conduction assembly 5 mainly includes a bottom heat pipe 51, a column heat pipe 52, and a top heat pipe 53. It should be noted that the number of the bottom heat pipe 51 and the top heat pipe 53 is not limited in the present invention. The number of the bottom heat pipe 51 and the top heat pipe 53 is set according to heat conduction requirement. The bottom heat pipe 51 is arranged at the bottom of the heat exchange cavity 1 and covers the bottom surface of the heat exchange cavity 1. Generally, a plurality of bottom heat pipes 51 are arranged and are mainly configured for absorbing heat from the heating element. The column heat pipe 52 is erected on a surface of each of the plurality of bottom heat pipes 51, extends to a predetermined height position of the cooling fin 41 vertically (in a height direction of the heat exchange cavity 1), for example, extend to a top position or a middle position of the cooling fin 41, and is mainly configured for achieving vertical heat transfer. The top heat pipe 53 is arranged at a top end of each of the plurality of column heat pipes 52, penetrates each cooling fin 41 in sequence, is connected to each cooling fin 41 respectively, and is mainly configured for transferring heat from the column heat pipe 52 to each cooling fin 41 respectively. In this way, part of the heat of the heating element is able to be transferred to the bottom heat pipe 51 through the bottom surface of the heat exchange cavity 1, and then transferred to upper portions through the column heat pipe 52, and finally transferred to each cooling fin 41 through the top heat pipe 53.

Further, for convenience of manufacturing, the top heat pipe 53 penetrates each cooling fin 41 in a direction perpendicular to the cooling fin 41. Moreover, a plurality of top heat pipes 53 are arranged on a same column heat pipe 52. For example, as for two top heat pipes 53, one top heat pipe 53 is connected to the top of the column heat pipe 52, and the other top heat pipe 53 is connected to the middle of the column heat pipe 52. In this way, heat is able to be simultaneously transferred to different height positions of each cooling fin 41 through the plurality of top heat pipes 53 with different height positions, and cooling temperature uniformity is able to be further improved.

Moreover, considering that the top surface of the heating element is usually a heat equalizing surface, in order to improve heat absorption uniformity of each bottom heat pipe 51 to the heating element, in the embodiment, each bottom heat pipe 51 extends in the arrangement direction of the cooling fin 41 and is uniformly distributed in the length direction of the cooling fin 41. Generally, three to five bottom heat pipes 51 are uniformly laid on the bottom surface of the heat exchange cavity 1. In this way, a coverage area of each bottom heat pipe 51 on the bottom surface of the heat exchange cavity substantially equals the area of the top surface of the heating element, such that heat is simultaneously absorbed from various positions on the top surface of the heating element, and the cooling temperature uniformity is further improved.

As shown in Fig. 5, Fig. 5 is a schematic diagram of a connection structure between a cooling fin 41 and a top heat pipe 53 according to an embodiment of the present invention.

In some embodiments of the cooling fin 41 and the top heat pipe 53, in order to conveniently penetrate each cooling fin 41 in sequence by the top heat pipe 53, in the embodiment, each cooling fin 41 is provided with a through hole. Moreover, since the top heat pipe 53 is perpendicular to the cooling fin 41, the contact area between each top heat pipe 53 and the cooling fin 41 is only an area of one circle of an inner wall of the through hole, and the contact area is small. In view of this, in the embodiment, an extension sleeve 42 is connected between walls of through holes of two adjacent cooling fins 41 of the plurality of cooling fins 41. This is equivalent to connecting the through holes of the two adjacent cooling fins 41 into a whole through the extension sleeve 42. After the top heat pipe 53 penetrates the through holes, the extension sleeve 42 sleeves on the top heat pipe 53. In this way, after the through holes of the two adjacent cooling fins 41 are connected by the extension sleeve 42, the through holes are elongated into tubes in an axial direction equivalently. The two adjacent cooling fins 41 make contact with the top heat pipe 53 through the tubular through holes, such that the heat exchange area between the top heat pipe 53 and the two adjacent cooling fins 41 is able to be greatly increased, and the efficiency of the top heat pipe 53 in transferring heat to the cooling fin 41 is able to be further improved.

Further, considering that after the through hole is formed in each cooling fin 41, the top heat pipe 53 is inserted into the through holes for connection and fixation to form a fin penetration process structure, and due to manufacturing errors and mounting errors, microscopic gaps are prone to form between an outer edge of the top heat pipe 53 and inner edges of the through holes of the cooling fins 41 or between an outer tube wall of the top heat pipe 53 and an inner tube wall of the extension sleeve 42. As a result, the top heat pipe 53 is not able to be tightly connected to the cooling fin 41, and the heat conduction efficiency between the top heat pipe 53 and the cooling fin 41 reduced. In view of this, in the embodiment, a gap between the outer tube wall of the top heat pipe 53 and the inner tube wall of the extension sleeve 42 is further filled with heat conduction flux for welding formation, such as solder. In this way, after the top heat pipe 53 is inserted into the through hole of each cooling fin 41, the gap between the outer tube wall of the top heat pipe 53 and the inner tube wall of the extension sleeve 42 is able to be filled with the heat conduction flux. Then the top heat pipe 53 and the cooling fin 41 are soldered by reflow soldering. Thus the gap between the outer edge of the top heat pipe 53 and the inner edge of the through hole of the cooling fin 41 is able to be eliminated. Accordingly, the heat conduction efficiency between the top heat pipe 53 and the cooling fin 41 is able to be improved.

Moreover, considering that on the motherboard of the server, dual central processing units or a plurality of graphic processing units may be used, such that the motherboard has a plurality of heating elements with large heat generation simultaneously. For this reason, a plurality of cold plates needs to be set on the motherboard for cooling respectively. In view of this, in the embodiment, a plurality of heat exchange cavities 1 are provided on the motherboard. The number of heat exchange cavities 1 is the same as the number of heating elements on the motherboard that need to be subjected to cold plate cooling, so as to achieve one-to-one correspondence. In some embodiments, each of the plurality of heat exchange cavities 1 is configured for abutting against different heating elements respectively, so as to absorb heat of the heating elements. Moreover, each of the plurality of heat exchange cavities 1 forms a series structure through the water inflow pipe 2 and the water outflow pipe 3. In this way, after entering a first heat exchange cavity 1 to absorb heat, the cooling liquid output by a cooling dispensing unit is able to enter a second heat exchange cavity 1 to continue absorbing heat until saturated and then flow back into the cooling dispensing unit, so as to continue circulating flow after being cooled again. Accordingly, it is guaranteed that the cooling liquid is fully used, and cooling waste is further reduced.

Certainly, for some heating elements with huge heat generation, such as some graphic processing units, the heat exchange cavity 1 corresponding to a heating element is able to be separately connected to the water inflow pipe 2 and the water outflow pipe 3, such that cold plate cooling is performed on the heating element separately through the cooling dispensing unit.

In another embodiment provided in the present invention, in order to improve the heat absorption efficiency of the heat exchange cavity 1 to the heating element, the cold plate cooling system of the air-liquid composite architecture includes the heat exchange cavity 1, the water inflow pipe 2, the water outflow pipe 3, the cooling assembly 4 and the heat conduction assembly 5, and further includes a heat conduction plate 10. In some embodiments, the heat conduction plate 10 is arranged on the bottom surface of the heat exchange cavity 1. A bottom surface of the heat conduction plate 10 is a smooth plane and is mainly configured for replacing the heat exchange cavity 1 to press against the top surface of the heating element and absorb heat of the heating element. Generally, the heat conduction plate 10, the heat exchange cavity 1, the cooling assembly 4, the heat conduction assembly 5 and other components are made of copper or other materials with high thermal conductivity to improve heat conduction efficiency.

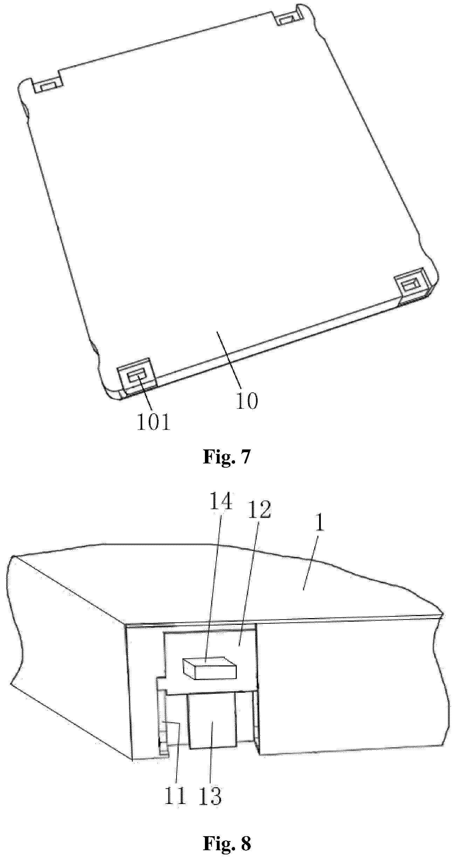

As shown in Fig. 7, Fig. 7 is a structural schematic diagram of a heat conduction plate 10 according to an embodiment of the present invention.

Further, considering that different types of heating elements have different sizes and areas, for example, different types of central processing units have different lengths, widths and sizes, and the sizes of the central processing units and the sizes of graphic processing units are generally different, in order to guarantee that the heat conduction plate 10 is able to stably cover the top surfaces of the heating elements with different sizes and areas, in the embodiment, the heat conduction plate 10 is detachably connected to the heat exchange cavity 1. Thus the heat conduction plate 10 matching a current heating element in size and area is detachable and replaceable on the heat exchange cavity 1, and universality of the heat conduction plate 10 is able to be achieved. In some embodiments, in the embodiment, a snap-fit groove 101 is provided on a top surface of each heat conduction plate 10 of different models. The forming position of the snap-fit groove 101 on each heat conduction plate 10 of different models is kept fixed. In this way, no matter which type of heat conduction plate 10 is selected, the heat conduction plate 10 is able to always be connected to the heat exchange cavity 1 through the snap-fit groove 101. Generally, a plurality of snap-fit grooves 101, for example, four to eight snap-fit grooves, are able to be formed on the heat conduction plate 10, and are located at two sides, two ends, corners, etc. of the heat conduction plate 10 respectively.

As shown in Fig. 8, Fig. 8 is a partial structural schematic diagram of a heat exchange cavity 1 according to an embodiment of the present invention.

In order to facilitate a detachment and replacement operation between the heat exchange cavity 1 and the heat conduction plate 10, in the embodiment, the heat exchange cavity 1 is provided with a guide chute 11, a guide slider 12, a snap-fit member 13, and an inserting-pulling operation block 14. The guide chute 11 is provided on the bottom surface of the heat exchange cavity 1 and extends vertically, that is, in the height direction of the heat exchange cavity 1. The guide slider 12 is mounted in the guide chute 11 and is able to slide along the guide chute 11, that is, vertically move up and down. The snap-fit member 13 is arranged at a bottom of the guide slider 12 and mainly configured for forming a snap-fit connection with the snap-fit groove 101 on the heat conduction plate 10, and includes a snap-fit post, a snap-fit block, etc. However, it is difficult to stably snap the snap-fit member 13 into the snap-fit groove 101 only by gravity of the guide slider 12 and the snap-fit member 13, such that the inserting-pulling operation block 14 is further arranged on a side wall of the guide slider 12. The inserting-pulling operation block 14 is mainly configured for a worker to apply a force to press down and pull up the inserting-pulling operation block 14, so as to apply a corresponding vertical force to the guide slider 12. Thus when pressed down, the snap-fit member 13 is inserted into the snap-fit groove 101 to form stable snap fit, or the snap-fit member 13 is pulled out from the snap-fit groove 101 to achieve separation and disassembly.

Further, in order to improve stability of snap-fit between the snap-fit member 13 and the snap-fit groove 101, in the embodiment, the snap-fit member 13 and the snap-fit groove 101 are magnetic members, so as to achieve attraction through the magnetic force when they are snapped with each other. Accordingly, connection stability is enhanced, and loosening is prevented. Similarly, the top end of the guide slider 12 and the top end of the guide chute 11 also have magnetism, such that the top end of the guide slider 12 is able to be attracted and fixed to the top end of the guide chute 11 through magnetic attraction, and the guide slider 12 is able to be prevented from accidentally falling.

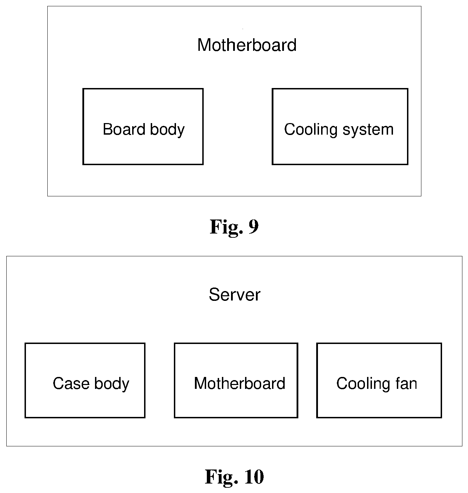

As shown in Fig. 9, the embodiment further provides a motherboard. The motherboard mainly includes a board body, a heating element arranged on a surface of the board body, and a cooling system for cooling the heating element. Since the cooling system uses all the technical solutions of the embodiments of the cold plate cooling system of the air-liquid composite architecture, the motherboard provided in the embodiment also has all the technical effects of the technical solutions of the above embodiments, which are not repeated herein.

As shown in Fig. 10, the embodiment further provides a server. The server mainly includes a case, a motherboard mounted in the case, and cooling fans arranged at two ends of the case. Since the motherboard uses all the technical solutions of the embodiment of the motherboard, the server provided in the embodiment also has all technical effects of the technical solutions of the above embodiment, which are not repeated herein.

The foregoing description of the disclosed embodiments enables those skilled in the art to make or use the present invention. Various modifications to these embodiments will be apparent to those skilled in the art, and the general principles defined herein are able to be achieved in other embodiments without departing from the spirit or scope of the present invention. Thus the present invention is to accord with the widest scope consistent with the principles and novel features disclosed herein instead of being limited to the embodiments described herein.

## Claims

1. A cold plate cooling system of an air-liquid composite architecture, comprising a heat exchange cavity (1), and a water inflow pipe (2) and a water outflow pipe (3) that are in communication with the heat exchange cavity (1), wherein an interior of the heat exchange cavity (1) is configured for accommodating cooling liquid, a bottom surface of the heat exchange cavity (1) is configured for abutting against a heating element, and the cold plate cooling system of the air-liquid composite architecture further comprises a cooling assembly (4) and a heat conduction assembly (5) that are mounted in the heat exchange cavity (1);
the cooling assembly (4) comprises a cooling fin (41), and there is at least one cooling fin (41), a bottom of the cooling fin (41) is connected to the bottom surface of the heat exchange cavity (1) and extends in a height direction of the heat exchange cavity (1), and a water outlet of the water inflow pipe (2) and a water inlet of the water outflow pipe (3) are located at two ends of the cooling fin (41) in a length direction respectively; and
a bottom of the heat conduction assembly (5) is connected to the bottom surface of the heat exchange cavity (1), and a top of the heat conduction assembly (5) is connected to a top of the cooling fin (41), part of heat absorbed by the heat exchange cavity (1) is transferred to the top of the cooling fin (41).

2. The cold plate cooling system of the air-liquid composite architecture as claimed in claim 1, wherein the water outlet of the water inflow pipe (2) and the water inlet of the water outflow pipe (3) are both in communication with a top of the heat exchange cavity (1), and are located at two ends of the heat exchange cavity (1) in a length direction respectively.

3. The cold plate cooling system of the air-liquid composite architecture as claimed in claim 1, wherein the water outlet of the water inflow pipe (2) is in communication with a top of the heat exchange cavity (1), the water inlet of the water outflow pipe (3) is in communication with a bottom of a side wall of the heat exchange cavity (1), and the water outlet of the water inflow pipe (2) and the water inlet of the water outflow pipe (3) are located at two ends of the heat exchange cavity (1) in a length direction respectively.

4. The cold plate cooling system of the air-liquid composite architecture as claimed in claim 1, wherein
a top wall of the heat exchange cavity (1) is a vapor chamber (6),
the top of the cooling fin (41) extends to be connected to the vapor chamber (6), and
the vapor chamber (6) is configured for naturally exchanging part of heat of the cooling fin (41) with outside air.

5. The cold plate cooling system of the air-liquid composite architecture as claimed in claim 4, wherein the cold plate cooling system of the air-liquid composite architecture is applied to a server, the server comprises a cooling fan, and a height of the heat exchange cavity (1) equals a height of an air duct formed by the cooling fan in the server.

6. The cold plate cooling system of the air-liquid composite architecture as claimed in claim 5, wherein the cooling assembly (4) comprises two cooling fins (41) at a head end and a tail end, side walls on two sides of the heat exchange cavity (1) in a width direction are heat conduction medium walls, the two cooling fins (41) at the head end and the tail end are attached to inner walls on the two sides of the heat exchange cavity (1) in the width direction respectively, and an air-cooling fin (7) is provided on outer walls on the two sides of the heat exchange cavity (1) in the width direction.

7. The cold plate cooling system of the air-liquid composite architecture as claimed in claim 1, wherein the bottom of the cooling fin (41) is welded to the bottom surface of the heat exchange cavity (1), and a thickness of the cooling fin (41) is 0.2 mm to 0.3 mm.

8. The cold plate cooling system of the air-liquid composite architecture as claimed in claim 7, wherein two side surfaces of the cooling fin (41) are provided with a protrusion and/or a recess to increase a surface area.

9. The cold plate cooling system of the air-liquid composite architecture as claimed in claim 1, wherein the cooling assembly (4) comprises a plurality of cooling fins (41), the heat conduction assembly (5) comprises a bottom heat pipe (51) covering the bottom surface of the heat exchange cavity (1), a column heat pipe (52) erected on a surface of the bottom heat pipe (51), and a top heat pipe (53) arranged at s top end of the column heat pipe (52);
the column heat pipe (52) extends vertically to a predetermined height position of the plurality of cooling fins (41); and
the top heat pipe (53) sequentially penetrates the plurality of cooling fins (41).

10. The cold plate cooling system of the air-liquid composite architecture as claimed in claim 9, wherein the top heat pipe (53) perpendicularly penetrates the plurality of cooling fins (41), and the top heat pipe (53) penetrates tops and/or middles of the plurality of cooling fins (41).

11. The cold plate cooling system of the air-liquid composite architecture as claimed in claim 10, wherein the cooling assembly (4) comprises the plurality of cooling fins (41), and the bottom heat pipe (51) extends in an arrangement direction of the plurality of cooling fins (41) and is uniformly distributed in a length direction of the plurality of cooling fins (41).

12. The cold plate cooling system of an air-liquid composite architecture as claimed in claim 9, wherein the cooling assembly (4) comprises the plurality of cooling fins (41), each of the plurality of cooling fins (41) is provided with a through hole allowing the top heat pipe (53) to penetrate, an extension sleeve (42) is connected between hole walls of through holes of two adjacent cooling fins (41) of the plurality of cooling fins (41), and the extension sleeve (42) is configured for sleeving on the top heat pipe (53).

13. The cold plate cooling system of the air-liquid composite architecture as claimed in claim 12, wherein a gap between an outer pipe wall of the top heat pipe (53) and an inner pipe wall of the extension sleeve (42) is filled with heat conduction flux for welding formation.

14. The cold plate cooling system of the air-liquid composite architecture as claimed in claim 1, wherein the cooling assembly (4) comprises a plurality of cooling fins (41), the cold plate cooling system of the air-liquid composite architecture further comprises a water distribution pipe (8) in communication with the water outlet of the water inflow pipe (2), the water distribution pipe (8) extends in an arrangement direction of the plurality of cooling fins (41), and a plurality of uniformly distributed water outlets are provided on the water distribution pipe (8).

15. The cold plate cooling system of the air-liquid composite architecture as claimed in claim 14, wherein the cooling assembly (4) comprises the plurality of cooling fins (41), the cold plate cooling system of the air-liquid composite architecture further comprises a water collection pipe (9) in communication with the water inlet of the water outflow pipe (3), the water collection pipe (9) extends in an arrangement direction of the plurality of cooling fins (41), and a plurality of uniformly distributed water inlets are provided on the water collection pipe (9).

16. The cold plate cooling system of the air-liquid composite architecture as claimed in claim 1, wherein a plurality of heat exchange cavities (1) are provided, each of the plurality of heat exchange cavities (1) is configured for abutting against different heating elements respectively, and each of the plurality of heat exchange cavities (1) is connected in series through the water inflow pipe (2) and the water outflow pipe (3).

17. The cold plate cooling system of the air-liquid composite architecture as claimed in any one of claims 1 to 16, wherein the cold plate cooling system of the air-liquid composite architecture further comprises a heat conduction plate (10) arranged on the bottom surface of the heat exchange cavity (1), a bottom surface of the heat conduction plate (10) is a smooth plane and is configured for pressing a top surface of the heating element and absorbing heat of the heating element.

18. The cold plate cooling system of the air-liquid composite architecture as claimed in claim 17, wherein the heat conduction plate (10) is detachably connected to the heat exchange cavity (1), and the heat conducting plate (10) matching the heating element in size is detachable and replaceable on the heat exchange cavity (1).

19. The cold plate cooling system of the air-liquid composite architecture as claimed in claim 18, wherein
a snap-fit groove (101) is provided at a fixed position on a top surface of the heat conduction plate (10);
a guide chute (11) extending vertically is provided on the bottom surface of the heat exchange cavity (1),
a guide slider (12) is arranged in the guide chute (11),
a bottom of the guide slider (12) is provided with a snap-fit member (13),
a side wall of the guide slider (12) is provided with an inserting-pulling operation block (14), and
the snap-fit member (13) is configured for forming a snap-fit connection with the snap-fit groove (101); and
the inserting-pulling operation block (14) is configured for applying a vertical force to the guide slider (12) to insert the snap-fit member (13) into the snap-fit groove (101) or pull the snap-fit member (13) out of the snap-fit groove (101).

20. The cold plate cooling system of the air-liquid composite architecture as claimed in claim 19, wherein
a top end of the guide slider (12) is magnetically connected to a top end of the guide chute (11); and/or
the snap-fit member (13) is magnetically connected to the snap-fit groove (101).

21. A motherboard, comprising a board body, a heating element arranged on a surface of the board body, and a cooling system for cooling the heating element, wherein the cooling system is the cold plate cooling system of the air-liquid composite architecture as claimed in any one of claims 1 to 20.

22. A server, comprising a case, a motherboard mounted in the case, and cooling fans arranged at two ends of the case, wherein the motherboard is the motherboard as claimed in claim 21.
